# EUROPEAN PATENT SPECIFICATION

(11) **EP 2 691 254 B1**
(45) Date of publication and mention of the grant of the patent: **14.09.2016**
(21) Application number: 12714839.3
(22) Date of filing: 29.03.2012
(51) Int. Cl.: G01R 35/00, B60L 11/18, B60L 3/00, G01R 31/36, H01M 10/48, H01M 10/44, H02J 7/00

(54) **CHARGING DEVICE FOR VEHICLE, VEHICLE EQUIPPED WITH CHARGING DEVICE, AND OFFSET CORRECTION METHOD FOR CURRENT SENSOR**
FAHRZEUGLADEEINRICHTUNG, FAHRZEUG MIT LADEEINRICHTUNG, UND VERSATZKORREKTURVERFAHREN FÜR STROMSENSOR
DISPOSITIF DE CHARGE POUR VÉHICULE, VÉHICULE ÉQUIPÉ DU DISPOSITIF DE CHARGE ET PROCÉDÉ DE CORRECTION DE DÉCALAGE POUR CAPTEUR DE COURANT

(30) Priority: 31.03.2011 JP 2011079352
(43) Date of publication of application: 05.02.2014
(73) Proprietor: Toyota Jidosha Kabushiki Kaisha, Toyota-shi, Aichi 471-8571 (JP)
(72) Inventor: MITSUTANI, Noritake, Aichi-ken 471-8571 (JP); KAMIYA, Kei, Kariya-City Aichi-Pref 448-8661 (JP)
(74) Representative: Intès, Didier Gérard André
(86) International application number: PCT/IB2012/000635
(87) International publication number: WO 2012/131480

(56) References cited:
- EP-A1- 2 107 385
- EP-A1- 2 246 956
- US-A1- 2003 001 544
- US-A1- 2004 018 419

## Description

### BACKGROUND OF THE INVENTION

### 1. Field of the Invention

The invention relates to a charging device for a vehicle, which is able to charge an electrical storage device using a power supply outside the vehicle, a vehicle equipped with the charging device, and an offset correction method for a current sensor.

### 2. Description of Related Art

As an environmentally friendly vehicle, a vehicle, such as an electric vehicle and a hybrid vehicle, has become a focus of attention. The electric vehicle is equipped with an electrical storage device, an inverter and an electric motor as a power source for propelling the vehicle. The electric motor is driven by the inverter. The hybrid vehicle is equipped with, in addition to an existing internal combustion engine, an electrical storage device, an inverter and an electric motor as a power source for propelling the vehicle. In such vehicles, in order to manage the input and output of the electrical storage device, a current sensor for detecting a current input to or output from the electrical storage device is provided.

Japanese Patent Application Publication No. 2008-72875 (JP 2008-72875 A) describes a current detection method that is used at the time when the current of a drive battery is detected by a current sensor in an electric vehicle. In this current detection method, in a current detection stop state (non-running and no load state where the vehicle is stopped and no current is supplied from the drive battery to a vehicle drive motor) where current detection of the drive battery may be temporarily stopped, the current sensor is isolated from a current detecting portion of a high-voltage line of the drive battery and then the offset value of the current sensor is detected while maintaining a state where electric power may be supplied from the drive battery to the motor. Then, the current detected by the current sensor is corrected using the detected offset value. A similar method is disclosed in US Patent Application Publication No. US 2004/0018419 A1.

With the current detection method described in JP 2008-72875 A, even in a state where the electric vehicle is allowed to run, the offset of the current sensor is accurately computed to thereby make it possible to highly accurately detect the current of the drive battery.

In recent years, in a hybrid vehicle as well as an electric vehicle, it has been suggested a configuration that an electrical storage device, such as a drive battery, is charged using a power supply outside the vehicle (hereinafter, also referred to as "external power supply") (hereinafter, charging the electrical storage device using the external power supply is also referred to as "external charging"). Then, in an externally chargeable vehicle, even during external charging, the offset of the current sensor that is used to detect a charging current for charging the electrical storage device needs to be corrected (hereinafter, also simply referred to as "offset learning") periodically.

When offset learning is performed during external charging, it is conceivable that the current detection method described in the above publication is applied and a charger is temporarily turned off to create a current detection stop state to thereby carry out offset learning. However, when the external power supply is connected to connected to the electrical storage device via the charger, in particular during charging of the electrical storage device, when the current is not actually zero because of a break in a stop command signal line, operation of an auxiliary load, or the like, despite the turn off command output to the charger, offset learning may not be accurately carried out.

### SUMMARY OF THE INVENTION

The invention provides a charging device that is able to accurately carry out offset learning of a current sensor during external charging in an externally chargeable vehicle.

A first aspect of the invention relates to a vehicle charging device. A targeted vehicle is able to charge an electrical storage device using an external power supply outside the vehicle. The charging device includes a charger, a current sensor and a controller. The charger receives electric power supplied from the external power supply to charge the electrical storage device. The current sensor detects a current input to or output from the electrical storage device. The controller carries out offset correction of the current sensor while the external power supply is connected to the electrical storage device via the charger, provided that: (i) electric devices, including the charger, that are electrically connected to the electrical storage device and that operate during charging of the electrical storage device using the external power supply are turned off; and (ii) a determination condition for determining that the current is zero on the basis of a value detected by the current sensor is satisfied. When the offset correction cannot be carried out, the controller executes a predetermined fail-safe process for preventing overcharging of the electrical storage device during charging of the electrical storage device using the external power supply, which includes a process of reducing an allowable input electric power that indicates an allowable value of electric power input to the electrical storage device.

The controller may carries out the offset correction of the current sensor in response to a command for the offset correction of the current sensor during charging of the electrical storage device while the external power supply is connected to the electrical storage device via the charger, provided that: (i) the electric devices, including the charger, that are electrically connected to the electrical storage device and that operate during charging of the electrical storage device using the external power supply are turned off; and (ii) the determination condition for determining that the current is zero on the basis of a value detected by the current sensor is satisfied.

(cancelled)

(cancelled)

When a voltage of the electrical storage device reaches a predetermined value during charging of the electrical storage device using the external power supply, the controller may execute forced charging control by which a charging current is reduced to charge the electrical storage device to a full charge state. The fail-safe process may include process of prohibiting the forced charging control.

The fail-safe process may include process of forcibly carrying out at least one of interrupting a power feed path through which electric power is supplied to the charger and interrupting a power feed path connecting the charger to the external power supply.

When a turn-off command is output to the electric devices, the controller may determine that the electric devices are turned off.

When the turn-off command is output to the electric devices and a response to the turn-off command is received from the electric devices, the controller may determine that the electric devices are turned off.

The electric devices may include an auxiliary load that operates during charging of the electrical storage device using the external power supply. The determination condition may be satisfied when the value detected by the current sensor is lower than a predetermined threshold.

The determination condition may be satisfied when no ripple fluctuations are detected in the value detected by the current sensor.

The determination condition may be satisfied when a variation in the value detected by the current sensor before and after the electric devices are turned off exceeds a predetermined threshold.

A vehicle may include an electrical storage device and the above described any one of the charging devices.

A second aspect of the invention relates to an offset correction method for a current sensor. The current sensor is used in a charging device for an externally chargeable vehicle. The vehicle includes an electrical storage device, a charger and the current sensor. The charger receives electric power supplied from the external power supply to charge the electrical storage device. The current sensor detects a current input to or output from the electrical storage device. Then, the offset correction method includes: determining whether electric devices, including the charger, that are electrically connected to the electrical storage device and that operate during charging of the electrical storage device using the external power supply are turned off; determining whether a determination condition for determining that the current is zero the basis of the value detected by the current sensor is satisfied on; and, carrying out offset correction of the current sensor in response to a command for offset correction of the current sensor when the external power supply is connected to the electrical storage device via the charger, provided that: (i) it is determined that the electric devices are turned off; and (ii) it is determined that the determination condition is satisfied. When the offset correction cannot be carried out, the controller executes a predetermined fail-safe process for preventing overcharging of the electrical storage device during charging of the electrical storage device using the external power supply, which includes a process of reducing an allowable input electric power that indicates an allowable value of electric power input to the electrical storage device.

(cancelled)

According to the aspects of the invention, offset correction (offset learning) of the current sensor is carried out while the external power supply is connected to the electrical storage device via the charger, provided that: (i) electric devices, including the charger, that are electrically connected to the electrical storage device and that operate during external charging are turned off; and (ii) a determination condition for determining that the current is zero on the basis of a value detected by the current sensor is satisfied. The offset learning is not carried out in a state where the current of the electrical storage device is not actually zero. Thus, according to the aspects of the invention, in an externally chargeable vehicle, it is possible to accurately carry out offset learning of the current sensor while the external power supply is connected to the electrical storage device via the charger, e.g., during charging the electrical storage device using the external power supply.

### BRIEF DESCRIPTION OF THE DRAWINGS

Features, advantages, and technical and industrial significance of exemplary embodiments of the invention will be described below with reference to the accompanying drawings, in which like numerals denote like elements, and wherein:
FIG. 1 is an overall block diagram of a vehicle that includes a charging device;
FIG 2 is a block diagram that shows the configuration of a controller;
FIG 3 is a functional block diagram of a charging control unit shown in FIG. 2;
FIG 4 is a functional block diagram of an electric power control unit shown in FIG 2;
FIG. 5 is a time chart of major signals in the controller;
FIG 6 is a flow chart that shows the procedure of offset learning carried out by the controller;
FIG. 7 is a functional block diagram of a charging control unit of a controller according to an embodiment of the invention;
FIG 8 is a graph for illustrating the allowable input electric power of an electrical storage device;
FIG 9 is a graph for illustrating forced charging of the electrical storage device;
FIG 10 is a time chart of major signals in the controller when offset learning fails;
FIG 11 is a flow chart that shows the procedure of the controller according to the embodiment; and
FIG 12 is an overall block diagram of a vehicle that includes a charging device according to an alternative embodiment.

### DETAILED DESCRIPTION OF EMBODIMENTS

Hereinafter, embodiments of the invention will be described in detail with reference to the accompanying drawings. Note that like reference numerals denote the same or corresponding components in the drawings and the description thereof will not be repeated basically.

### First Embodiment

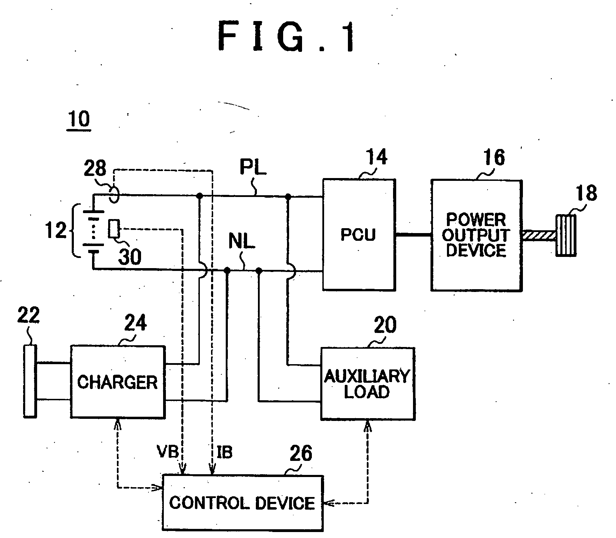

FIG 1 is an overall block diagram of a vehicle that includes a charging device. As shown in FIG 1, the vehicle 10 includes an electrical storage device 12, a power control unit (hereinafter, referred to as "PCU") 14, a power output device 16, a drive wheel 18 and an auxiliary load 20. In addition, the vehicle 10 further includes an inlet 22, a charger 24, a controller 26, a current sensor 28 and a voltage sensor 30.

The electrical storage device 12 is a rechargeable direct-current power supply, and is, for example, formed of a secondary battery, such as a nickel metal hydride battery and a lithium ion battery. The electrical storage device 12 stores not only electric power supplied from an external power supply and input from the inlet 22 but also electric power generated by the power output device 16. Note that a capacitor having a relatively large capacitance may be employed as the electrical storage device 12.

The PCU 14 represents an overall electric power conversion device that receives electric power from the electrical storage device 12 to drive the power output device 16. For example, the PCU 14 includes an inverter, a converter, and the like.

The inverter is used to drive a motor included in the power output device 16. The converter steps up electric power, output from the electrical storage device 12, and then supplies the stepped-up electric power to the inverter.

The power output device 16 is an overall device for driving the drive wheel 18. For example, the power output device 16 includes a motor, an engine, and the like, that drive the drive wheel 18. In addition, the power output device 16 generates electric power through operation of the motor, which drives the drive wheel 18, in a regeneration mode during braking of the vehicle, or the like, and then outputs the generated electric power to the PCU 14.

The auxiliary load 20 is connected to a positive electrode line PL and a negative electrode line NL that are connected to the electrical storage device 12. The auxiliary load 20 represents all auxiliaries that operate during external charging, and, for example, includes a DC/DC converter, an electric air conditioner, and the like. The DC/DC converter generates auxiliary voltage by stepping down the voltage of the positive electrode line PL.

The inlet 22 is configured to be connectable with the connector of a charging cable for supplying electric power from an external power supply (not shown) to the vehicle 10. Then, during external charging, the inlet 22 receives electric power supplied from the external power supply.

The charger 24 is connected to the positive electrode line PL and the negative electrode line NL. The charger 24 converts electric power input from the inlet 22 to a predetermined charging voltage (direct current) on the basis of a control signal from the controller 26. Then, electric power of which the voltage is converted by the charger 24 is supplied to the electrical storage device 12 to charge the electrical storage device 12.

The current sensor 28 detects a current IB input to or output from the electrical storage device 12, and outputs the detected value to the controller 26. The voltage sensor 30 detects the voltage VB of the electrical storage device 12, and outputs the detected value to the controller 26.

The controller 26 executes various processings for controlling charging of the electrical storage device 12 by the charger 24 during external charging. Specifically, the controller 26 generates a start-up command for the charger 24, a turn-off command for the charger 24, an electric power command that indicates a target value of charging electric power, or the like, and outputs the generated command to the charger 24. In addition, the controller 26 carries out offset learning of the current sensor 28 during external charging. Specifically, as the charger 24 and the auxiliary load 20 turn off and a determination condition for determining that the current IB is zero on the basis of the detected value of the current sensor 28, the controller 26 carries out offset learning of the current sensor 28.

Note that, in this example, the auxiliary load 20 receives electric power from the positive electrode line PL and the negative electrode line NL to which the electrical storage device 12 is connected, so the condition for carrying out offset learning of the current sensor 28 includes a turn-off of the auxiliary load 20; however, when the power supply of the auxiliary load 20 is independent of the electrical storage device 12, the condition for carrying out offset learning does not need to include a turn-off of the auxiliary load 20.

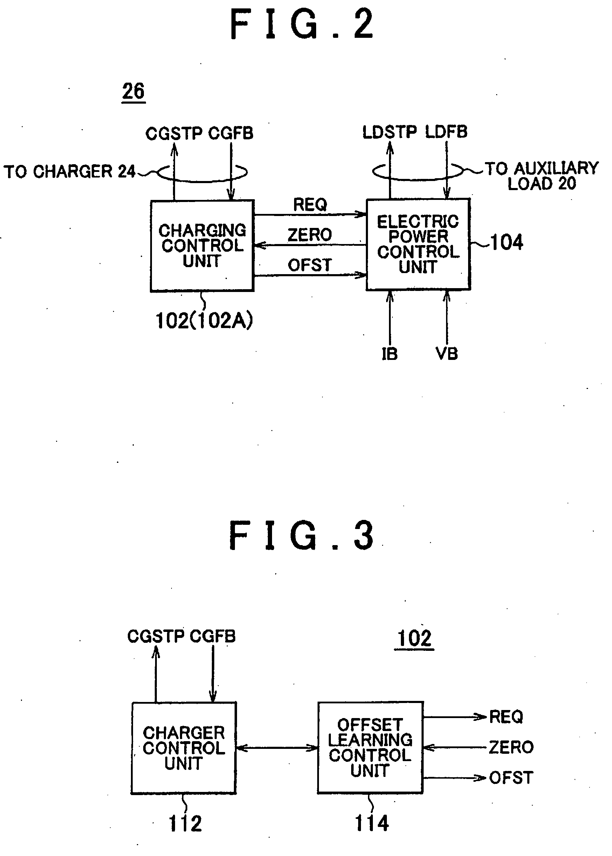

FIG 2 is a block diagram that shows the configuration of the controller 26. As shown in FIG 2, the controller 26 includes a charging control unit 102 and an electric power control unit 104. As external charging is requested, the charging control unit 102 outputs the start-up command to the charger 24, generates a driving signal for controlling the output electric power of the charger 24 to a predetermined target value and then outputs the generated driving signal to the charger 24.

In addition, the charging control unlit 102 periodically carries out offset learning of the current sensor 28 at predetermined intervals during external charging. Specifically, as offset learning is requested, the charging control unit 102 outputs a turn-off command CGSTP, which instructs the charger 24 to turn off, to the charger 24, and outputs a load turn-off request command REQ, which requests a turn-off of the auxiliary load 20, to the electric power control unit 104.

Note that the charging control unit 102 may determine that the charger 24 is turned off when the turn-off command CGSTP is output to the charger 24 or may determine that the charger 24 is turned off when a feedback (F/B) signal CGFB is received from the charger 24 in response to the turn-off command CGSTP. Similarly, for determination as to a turn-off of the auxiliary load 20 as well, the charging control unit 102 may determine that the auxiliary load 20 is turned off when the load turn-off request command REQ is output to the electric power control unit 104 or when a turn-off command LDSTP is output from the electric power control unit 104 to the auxiliary load 20 in response to the load turn-off request command REQ, or may determine that the auxiliary load 20 is turned off when an F/B signal LDFB is received from the auxiliary load 20 in response to the turn-off command LDSTP.

In addition, the charging control unit 102 receives a current stop determination signal ZERO, which indicates the determination result of current stop determination (described later) executed by the electric power control unit 104, from the electric power control unit 104. Then, in the case where offset learning is requested, when the charger 24 and the auxiliary load 20 are turned off and the current stop determination signal ZERO indicates that the input/output currents of the electrical storage device are zero, the charging control unit 102 outputs a command OFST, which provides instructions to carry out offset correction, to the electric power control unit 104.

As the electric power control unit 104 receives the load turn-off request command REQ from the charging control unit 102, the electric power control unit 104 outputs the turn-off command LDSTP, which provides instructions to turn off the auxiliary load 20, to the auxiliary load 20. In addition, the electric power control unit 104 receives the F/B signal LDFB, which indicates that the auxiliary load 20 is turned off in response to the turn-off command LDSTP, from the auxiliary load 20.

In addition, the electric power control unit 104 executes current stop determination for determining whether the current IB is actually zero on the basis of the detected current IB received from the current sensor 28. A method for the current stop determination will be described later. As it is determined that the current IB is actually zero through the current stop determination, the electric power control unit 104 provides a notification of the determination result to the charging control unit 102 through the current stop determination signal ZERO. Then, as the electric power control unit 104 receives the command OFST from the charging control unit 102, the electric power control unit 104 carries out offset learning of the current sensor 28. Specifically, the electric power control unit 104 carries out offset correction of the current sensor 28 so as to recognize the value detected by the current sensor 28 at this time as zero.

Note that the charging control unit 102 and the electric power control unit 104 may be configured as separate electronic control units (ECUs) or may be configured on the same ECU.

FIG. 3 is a functional block diagram of the charging control unit 102 shown in FIG 2. As shown in FIG 3, the charging control unit 102 includes a charger control unit 112 and an offset learning control unit 114. The charger control unit 112 generates the start-up command of the charger 24, a target value of charging electric power, a driving signal of the charger 24 for controlling charging electric power to the target value, or the like, on the basis of a request to carry out external charging and then outputs the generated command, value or signal to the charger 24.

In addition, as the requirement to carry out offset learning is satisfied in the offset learning control unit 114, the charger control unit 112 outputs the turn-off command CGSTP to the charger 24. Then, as the charger control unit 112 receives the F/B signal CGFB from the charger 24 in response to the turn-off command CGSTP, the charger control unit 112 provides a notification of that effect to the offset learning control unit 114.

The offset learning control unit 114 periodically carries out offset learning of the current sensor 28 at predetermined intervals during external charging. Specifically, as offset learning is requested, the offset learning control unit 114 provides a notification of that effect to the charger control unit 112, and outputs the load turn-off request command REQ to the electric power control unit 104 (FIG 2).

Then, as the offset learning control unit 114 determines that the charger 24 and the auxiliary load 20 are turned off and determines that the current IB of the electrical storage device 12 is zero on the basis of the current stop determination signal ZERO received from the electric power control unit 104, the offset learning control unit 114 outputs a command OFST, which provides instructions to carry out offset learning of the current sensor 28, to the electric power control unit 104.

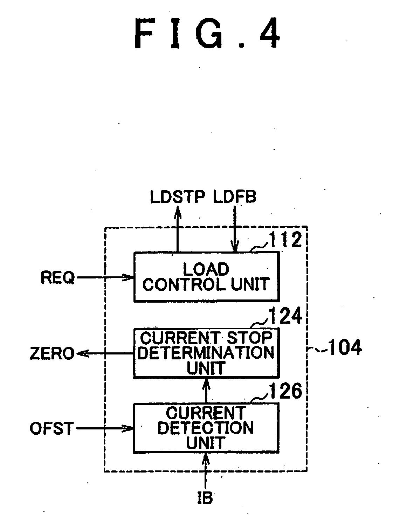

FIG 4 is a functional block diagram of the electric power control unit 104 shown in FIG. 2. As shown in FIG 4, the electric power control unit 104 includes a load control unit 122, a current stop determination unit 124 and a current detection unit 126. As the load control unit 122 receives the load turn-off request command REQ from the charging control unit 102 (FIG 2 and FIG 3), the load control unit 122 outputs the turn-off command LDSTP to the auxiliary load 20. In addition, the load control unit 122 receives the F/B signal LDFB, which indicates that the auxiliary load 20 is turned off in response to the turn-off command LDSTP, from the auxiliary load 20.

The current stop determination unit 124 executes current stop determination for determining whether the current IB is actually zero on the basis of the detected current IB received from the current detection unit 126. For example, when the absolute value of the current IB is smaller than a predetermined threshold (which is set at a small value), it is determined that the current IB is zero. Alternatively, when no ripple fluctuations are found in the detected current IB, it may be determined that the current IB is zero. Alternatively, when a variation in the current IB exceeds a predetermined threshold before and after a turn-off of the charger 24 and auxiliary load 20 resulting from offset learning, it may be determined that the current IB is zero. Note that it may be determined that the current IB is zero using an appropriate combination of these determination methods. Then, the current stop determination unit 124 outputs the current stop determination signal ZERO, which indicates the result of current stop determination, to the charging control unit 102.

The current detection unit 126 receives the detected current IB from the current detection unit 126. Then, as the current detection unit 126 receives the command OFST from the charging control unit 102, the current detection unit 126 carries out offset correction of the current sensor 28 so as to recognize that the value detected by the current sensor 28 at that time is zero. In addition, the current detection unit 126 outputs the value detected by the current sensor 28 or the detected current IB after offset correction to the current stop determination unit 124.

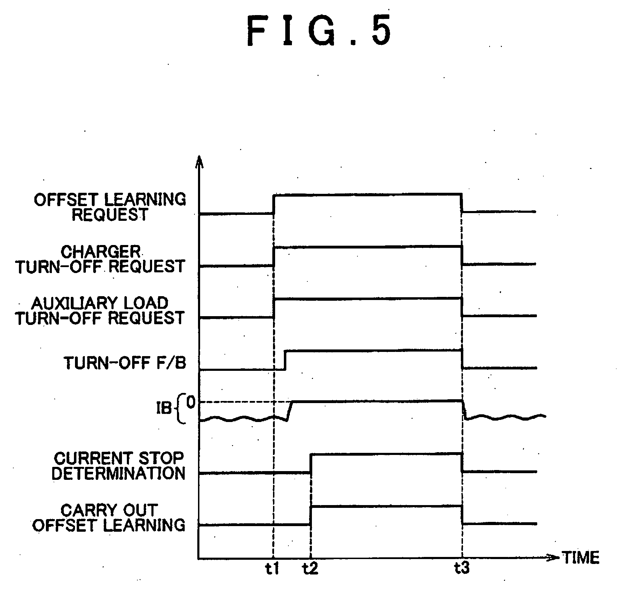

FIG. 5 is a time chart of major signals in the controller 26. As shown in FIG 5, it is assumed that offset learning of the current sensor 28 is requested at time t1.. Note that offset learning of the current sensor 28 is periodically carried out at predetermined intervals during external charging. As offset learning is requested, the turn-off command CGSTP is output from the controller 26 to the charger 24 to thereby request a turn-off of the charger 24. In addition, the load turn-off request command REQ is output from the charging control unit 102 to the electric power control unit 104 (FIG 2) in the controller 26, and the turn-off command LDSTP is output from the controller 26 to the auxiliary load 20 in response to the load turn-off request command REQ to thereby request a turn-off of the auxiliary load 20.

As the charger 24 turns off in response to the request to turn off the charger 24, the F/B signal CGFB, which indicates that the charger 24 is turned off, is output from the charger 24 to the controller 26. Similarly, as the auxiliary load 20 turns off in response to the request to turn off the auxiliary load 20, the F/B signal LDFB, which indicates that the auxiliary load 20 is turned off, is output from the auxiliary load 20 to the controller 26. Then, as the charger 24 and the auxiliary load 20 turn off, the detected current IB indicates a value near zero. Note that, because there is an offset of the current sensor 28, the detected value does not always indicate zero.

Furthermore, at time t2, current stop determination that determines whether the current IB is actually zero is executed on the basis of the detected current IB. Then, when it is determined that the current IB is actually zero, the offset learning condition is satisfied, and offset learning of the current sensor 28 is carried out. When offset learning is completed, a turn-off of the charger 24 and auxiliary load 20 is cancelled and external charging is resumed by the charger 24 at time t3.

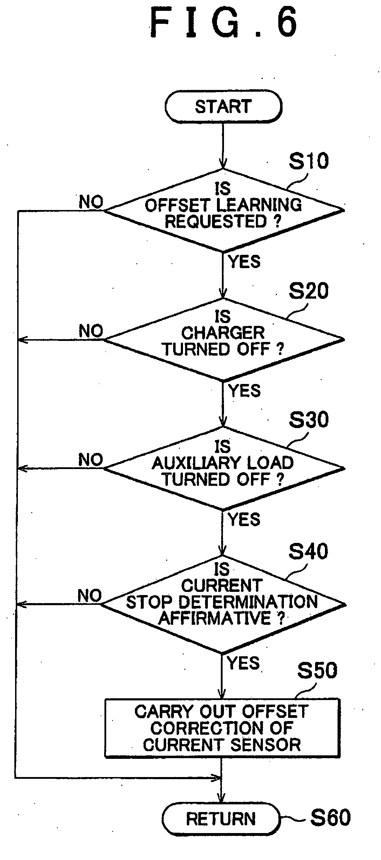

FIG. 6 is a flow chart that shows the procedure of offset learning carried out by the controller 26. Note that a series of processes shown in this flow chart are executed at constant time intervals or each time a predetermined condition is satisfied during external charging.

As shown in FIG 6, the controller 26 determines whether offset learning of the current sensor 28 is requested (step S10). Note that, as described above, offset learning is periodically carried out at predetermined intervals during external charging. When it is determined that offset learning is not requested (NO in step S10), the controller 26 causes the process to proceed to step S60 without executing the following series of processes.

When it is determined in step S10 that offset learning is requested (YES in step S10), the controller 26 outputs the turn-off command CGSTP to the charger 24 and outputs the turn-off command LDSTP to the auxiliary load 20. Subsequently, the controller 26 determines whether the charger 24 is turned off (step S20). Note that determination as to a turn-off of the charger 24 may be made by determining that the charger 24 is turned off at the time when the turn-off command CGSTP is output to the charger 24 or determining that the charger 24 is turned off at the time when the F/B signal CGFB is received from the charger 24 in response to the turn-off command CGSTP.

When it is determined that the charger 24 is not turned off (NO in step S20), the controller 26 causes the process to proceed to step S60 without carrying out offset learning. When it is determined in step S20 that the charger 24 is turned off (YES in step S20), the controller 26 determines whether the auxiliary load 20 is turned off (step S30). Note that determination as to a turn-off of the auxiliary load 20 may also be made by determining that the auxiliary load 20 is turned off at the time when the turn-off command LDSTP is output to the auxiliary load 20 or determining that the auxiliary load 20 is turned off at the time when the F/B signal LDFB is received from the auxiliary load 20 in response to the turn-off command LDSTP

When it is determined that the auxiliary load 20 is not turned off (NO in step S30), the controller 26 causes the process to proceed to step S60 without carrying out offset learning. When it is determined in step S30 that the auxiliary load 20 is turned off (YES in step S30), the controller 26 determines whether the current stop determination that indicates that the current IB is actually zero is affirmative (step S40).

As described above, for example, when the absolute value of the current IB is smaller than a predetermined threshold, when no ripple fluctuations are found in the detected current IB or when a variation in the current IB exceeds a predetermined threshold before and after a turn-off of the charger 24 and auxiliary load 20 resulting from offset learning, it is determined that the current stop determination is affirmative. Note that it may be determined whether the current IB is actually zero using an appropriate combination of these conditions.

Then, when it is determined in step S40 that the current stop determination is affirmative (YES in step S40), the controller 26 carries out offset correction (offset learning) of the current sensor 28 (step S50). Note that, when the current stop determination is negative (NO in step S40), the process proceeds to step S60 without executing step S50.

As described above, during external charging, when all the electric devices (the charger 24 and the auxiliary load 20) that are electrically connected to the electrical storage device 12 and that operate during external charging are turned off and the current stop determination for determining that the current IB is zero on the basis of the value detected by the current sensor 28 is affirmative, offset learning of the current sensor 28 is carried out, so offset learning is not carried out in a state where the current IB of the electrical storage device 12 is actually not zero. Thus, according to this example, in the externally chargeable vehicle 10, it is possible to accurately carry out offset learning of the current sensor 28 during external charging.

### Embodiment

When offset learning of the current sensor 28 cannot be properly carried out because of negative current stop determination, or the like, the electrical storage device 12 may be overcharged if external charging is continued in that state. Specifically, when the value detected by the current sensor 28 is offset to a discharging side, the current sensor 28 recognizes that a charging current that is smaller than an actual charging current flows as the charging current. As a result, during external charging, a charging current that exceeds an upper limit may flow.

In addition, when the value detected by the current sensor 28 is offset to a charging side, the current sensor 28 recognizes that a charging current that is larger than an actual charging current flows as the charging current. Here, for full charge determination during external charging, the open circuit voltage (OCV) of the electrical storage device 12, which correlates with the state of charge (SOC) of the electrical storage device 12, is used, and the OCV is estimated by subtracting an increase in voltage due to internal resistance from the closed circuit voltage (CCV), that is, the voltage VB of the electrical storage device 12, during charging. Thus, when the current sensor 28 erroneously recognizes that a charging current that is larger than an actual charging current flows as the charging current, the current sensor 28 erroneously recognizes the OCV at a value lower than an actual value at the time when the OCV is estimated from the voltage VB of the electrical storage device 12. As a result, full charge determination based on the OCV delays, so the electrical storage device 12 is overcharged.

Then, in an embodiment of the invention, when offset learning of the current sensor 28 cannot be properly carried out, fail-safe process for preventing overcharging of the electrical storage device 12 is executed. Specifically, when offset learning is not properly carried out, the allowable input electric power Win that indicates the allowable value of input electric power of the electrical storage device 12 is reduced or the charging current is reduced as the electrical storage device 12 gets close to the full charge state to prohibit forced charging (described in detail later) that carries out charging to the full charge state.

The overall configuration of the vehicle in the embodiment is the same as the vehicle 10 in the example shown in FIG 1.

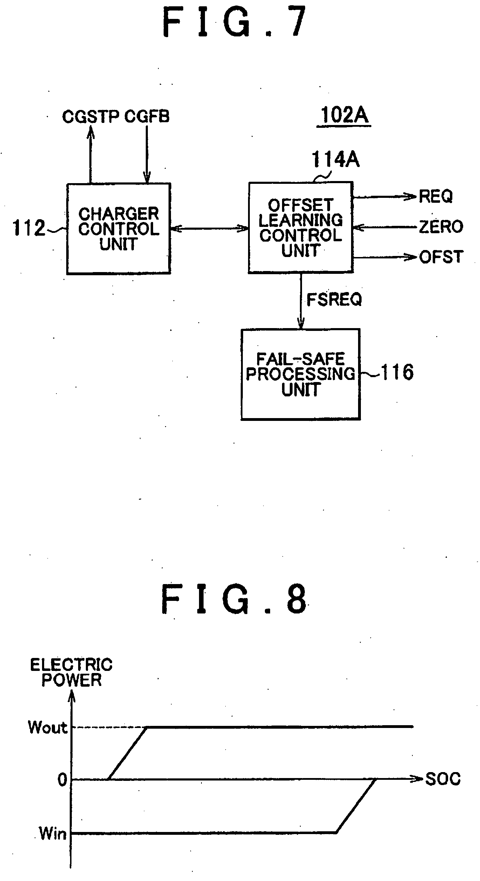

FIG 7 is a functional block diagram of a charging control unit 102A of a controller 26 according to the embodiment. As shown in FIG. 7, the configuration of the charging control unit 102A differs from the configuration of the charging control unit 102 in the example shown in FIG 3 in that the charging control unit 102A includes an offset learning control unit 114A instead of the offset learning control unit 114 and further includes a fail-safe processing unit 116.

When offset learning of the current sensor 28 cannot be properly carried out because of negative current stop determination, or the like, the offset learning control unit 114A outputs an FS process request command FSREQ, which provides instructions to execute fail-safe process, to the fail-safe processing unit 116. Note that the other configuration of the offset learning control unit 114A is the same as that of the offset learning control unit 114 shown in FIG 3.

As the fail-safe processing unit 116 receives the FS process request command FSREQ from the offset learning control unit 114A, the fail-safe processing unit 116 executes fail-safe process for preventing overcharging of the electrical storage device 12.

As an example of the fail-safe process, the fail-safe processing unit 116 executes process of relatively reducing the allowable input electric power Win of the electrical storage device 12 each time offset learning that is scheduled to be periodically carried out fails.

FIG 8 is a graph for illustrating the allowable input electric power Win of the electrical storage device 12. As shown in FIG 8, the abscissa axis represents the SOC of the electrical storage device 12, and the ordinate axis represents an allowable value of electric power input to or output from the electrical storage device 12 where discharging is positive (charging is negative). The allowable input electric power Win is set on the basis of the SOC of the electrical storage device 12. Note that the allowable input electric power Win may be varied on the basis of the temperature of the electrical storage device 12. Note that the allowable output electric power Wout that indicates the allowable value of output electric power of the electrical storage device 12 is also set for discharging.

When offset learning of the current sensor 28 fails, the fail-safe processing unit 116 reduces the allowable input electric power Win by a predetermined amount from the value at that time (reduces the absolute value). For example, the largest offset amount that can occur in the current sensor 28 in an interval (time) during which offset learning is carried out is used to calculate the correction amount of the allowable input electric power Win. That is, the amount of occurrence of offset per unit temperature variation is determined by specification for the current sensor 28. Then, a temperature variation amount that can occur in an interval (time) during which offset learning is carried out is estimated and then, on the basis of the estimated temperature variation amount, a largest offset amount ΔA that can occur after previous offset learning is calculated. By multiplying the ΔA by the voltage VB of the electrical storage device 12, the correction amount of the allowable input electric power Win at the time when offset learning has failed may be set.

Note that, when offset learning is not properly carried out successively, the allowable input electric power Win is also corrected successively (in a stepwise manner). Then, when once offset learning is properly carried out, the allowable input electric power Win is returned to the original level before correction.

As another example of fail-safe process, when offset learning has failed, the fail-safe processing unit 116 may prohibit forced charging by which a charging current is reduced as the electrical storage device 12 gets close to the full charge state to carry out charging to the full charge state.

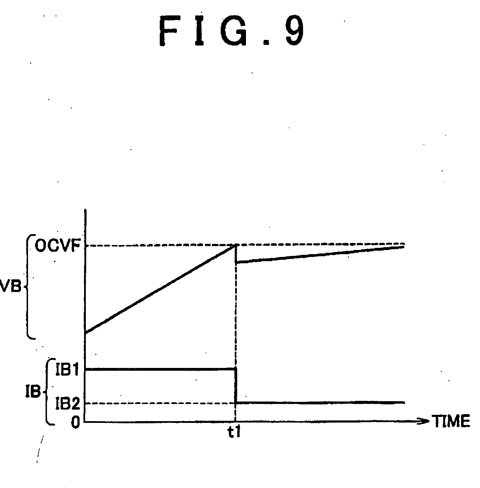

FIG 9 is a graph for illustrating forced charging of the electrical storage device 12. As shown in FIG 9, during external charging, by the time when the voltage VB of the electrical storage device 12 reaches a value OCVF, charging is carried out by setting the charging current at IB1 within the range that does not exceed a rating. Note that the value OCVF is an open circuit voltage (OCV) at the time when the electrical storage device 12 is a full charge state, and, even when the voltage VB reaches the value OCVF at time t1, the voltage VB at this time is a closed circuit voltage (CCV), so the SOC of the electrical storage device 12 has not reached the full charge state.

When the voltage VB (CCV) reaches the value OCVF at time t1, the magnitude of charging current is changed from IB1 (large current) to IB2 (small current), and then charging is carried out. In the case of a small charging current, the voltage VB (CCV) is close to the OCV, so it is possible to sufficiently carry out charging barely to the full charge state on the basis of the detected voltage VB. Carrying out charging to the full charge state by reducing a charging current, which is carried out after time t1, is termed "forced charging". Then, when offset learning fails, the fail-safe processing unit 116 prohibits the forced charging. By so doing, overcharging of the electrical storage device 12 is prevented.

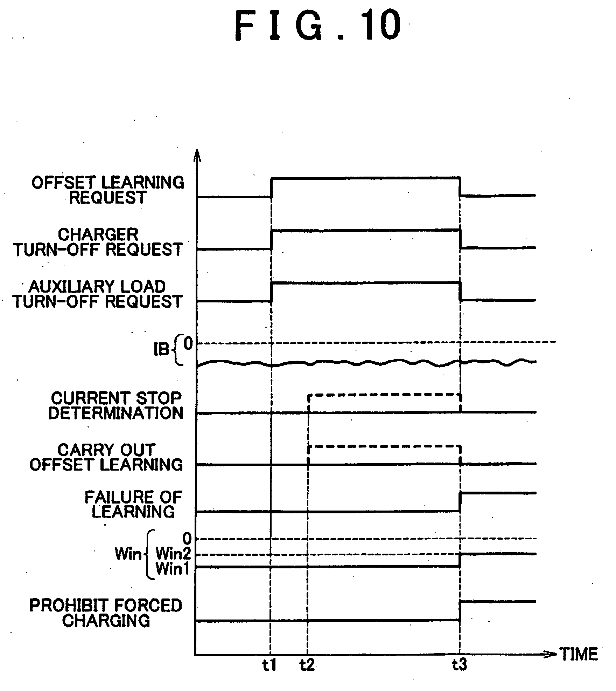

FIG. 10 is a time chart of major signals in the controller 26 when offset learning fails. As shown in FIG 10, offset learning of the current sensor 28 is requested at time t1, and a turn-off of the charger 24 and auxiliary load 20 is requested. However, at least one of the charger 24 and the auxiliary load 20 does not turn off because of an abnormality (such as a break in a stop command line), and the current IB does not become zero.

At time t2, current stop determination is executed by the controller 26; however, it is determined that the current IB is not zero and, as a result, offset learning is not carried out. Then, at time t3, a failure of offset learning has been detected, and the allowable input electric power Win of the electrical storage device 12 is changed from Win1 to Win2 (|Win2| < |win1|), and forced charging of the electrical storage device 12 is prohibited.

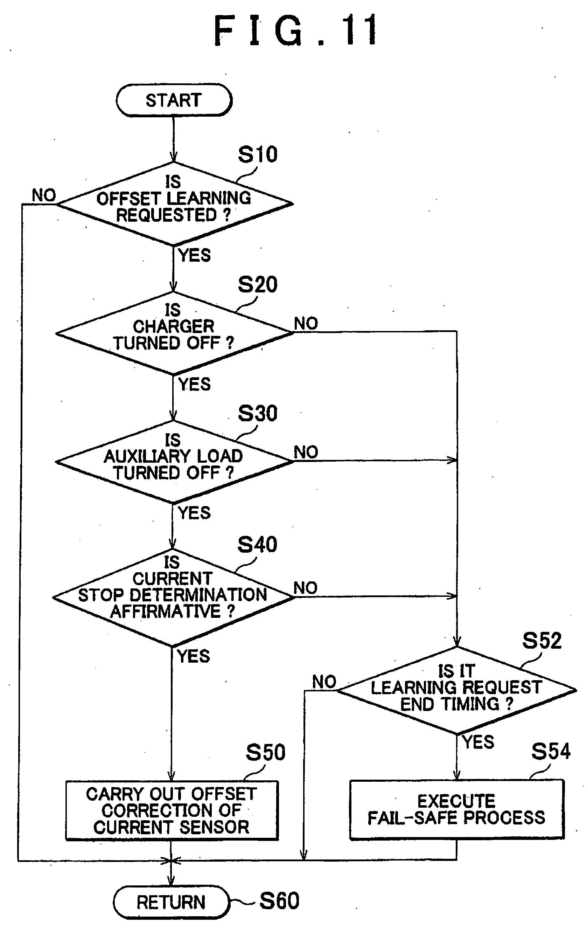

FIG 11 is a flow chart that shows the procedure of the controller 26 in the second embodiment. Note that a series of processes shown in this flow chart are also executed at constant time intervals or each time a predetermined condition is satisfied during external charging.

As shown in FIG. 11, the flow chart further includes step S52 and step S54 as compared with the flow chart shown in FIG. 6. That is, when it is determined in step S20 that the charger 24 is not turned off (NO in step S20), when it is determined in step S30 that the auxiliary load 20 is not turned off (NO in step S30) or when it is determined in step S40 that current stop determination is negative (NO in step S40), the controller 26 determines whether a request for offset learning is ended (step S52). Note that the learning request end timing is appropriately determined on the basis of a period of time required for offset learning when offset learning is properly carried out.

Then, when it is determined in step S52 that a request for offset learning is ended (YES in step S52), the controller 26 determines that offset learning has failed and then executes the above described fail-safe process for preventing overcharging of the electrical storage device 12 (step S54). Specifically, the allowable input electric power Win of the electrical storage device 12 is reduced or forced charging that is carried out when the electrical storage device 12 gets close to the full charge state is prohibited.

As described above, in the embodiment, when offset learning of the current sensor 28 cannot be properly carried out during external charging, fail-safe process, in which the allowable input electric power Win of the electrical storage device 12 is reduced or forced charging that is carried out when the electrical storage device 12 gets close to the full charge state is prohibited, is executed. Thus, according to the second embodiment, it is possible to prevent overcharging of the electrical storage device 12 during external charging.

### Alternative Embodiment

When offset learning of the current sensor 28 cannot be carried out, supply of electric power to the electrical storage device 12 may be stopped by interrupting the charger 24 and/or interrupting a power feed path from the external power supply.

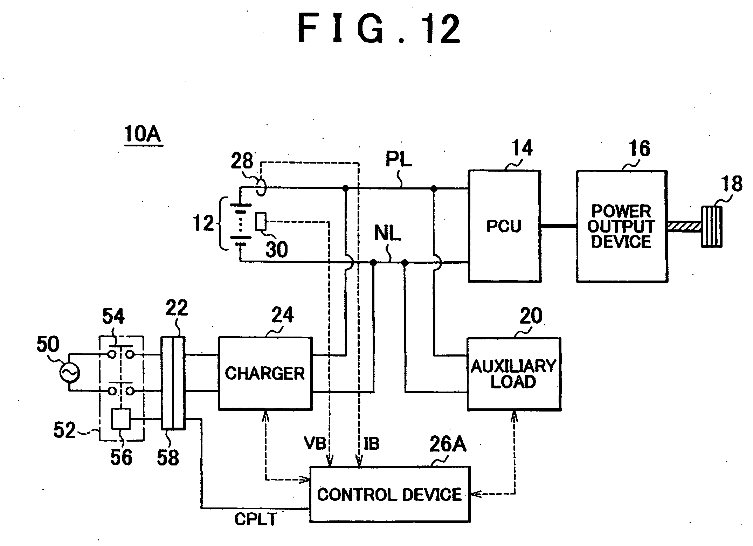

FIG 12 is an overall block diagram of a vehicle that includes a charging device according to an alternative embodiment. As shown in FIG. 12, the vehicle 10A includes a controller 26A instead of the controller 26 in the configuration of the vehicle 10 shown in FIG 1.

An external power supply 50, an electric vehicle supply equipment (EVSE) 52 and a connector 58 are provided outside the vehicle 10A. The EVSE 52 includes a charging circuit interrupt device (CCID) 54 and a CPLT control circuit 56.

The external power supply 50 is provided outside the vehicle, and is, for example, formed of a commercial system power supply. The EVSE 52 is configured to be able to interrupt an electric path for supplying electric power from the external power supply 50 to the vehicle 10A. The EVSE 52 is, for example, provided for a charging cable for supplying electric power from the external power supply 50 to the vehicle 10A or in a charging station for supplying electric power to the vehicle 10A via a charging cable. The CCID 54 is an interrupter provided in a power feed path from the external power supply 50 to the vehicle 10A, and is controlled by the CPLT control circuit 56.

The CPLT control circuit 56 generates a pilot signal CPLT, and outputs the generated pilot signal CPLT to the vehicle 10A via a control pilot line. The potential of the pilot signal CPLT is operated by the controller 26A of the vehicle 10A, and the CPLT control circuit 56 controls the CCID 54 on the basis of the potential of the pilot signal CPLT. That is, by operating the potential of the pilot signal CPLT in the controller 26A of the vehicle 10A, it is possible to remotely operate the CCID 54 from the vehicle 10A. Note that the pilot signal CPLT is, for example, in compliant with "SAEJ1772 (SAE Electric Vehicle Conductive Charge Coupler)" in the United States of America.

The controller 26A executes on/off operation of the CCID 54 of the EVSE 52 during external charging. On/off operation of the CCID 54 is remotely operated by the controller 26A using the pilot signal CPLT That is, the controller 26A operates the potential of the pilot signal CPLT, received from the CPLT control circuit 56 of the EVSE 52, to remotely operate the CCID 54.

Then, when offset learning of the current sensor 28 fails, the controller 26A outputs an interruption command (gate interruption) to the charger 24 and operates the potential of the pilot signal CPLT to forcibly turn off the CCID 54. Note that the controller 26A may be configured to execute only any one of interruption of the charger 24 and interruption of the CCID 54.

Note that the other configuration of the controller 26A is the same at that of the controller 26 shown in FIG. 1. As described above, according to the alternative embodiment, when offset learning of the current sensor 28 cannot be carried out during external charging, the charging electric path is interrupted in the charger 24 and/or the CCID 54, so it is possible to reliably prevent overcharging of the electrical storage device 12 during external charging.

Note that, in the above description, the vehicles 10 and 10A may be an electric vehicle on which no engine is mounted or may be a hybrid vehicle on which both a motor and an engine are mounted as power sources, and, in addition, may be a fuel-cell vehicle on which a fuel cell is further mounted as a direct-current power supply.

According to this embodiment as described above, the offset correction of the current sensor is carried out during charging of the electrical storage device. However, the invention is not limited to this embodiment. For example, the offset correction of the current sensor may be carried out while the external power supply is connected to the electrical storage device via the charger. In addition, even if there no command for the offset correction of the current sensor, the offset correction of the current sensor may be carried out at each predetermined period of time, or when a predetermined condition is satisfied.

The embodiments described above are illustrative and not restrictive in all respects. The scope of the invention is defined by the appended claims rather than the above description. The scope of the invention is intended to encompass all modifications within the scope of the appended claims and equivalents thereof.

## Claims

1. A charging device for a vehicle (10; 10A), which charges an electrical storage device (12) using an external power supply outside the vehicle, the charging device comprising:
a charger (24);
a current sensor (28) for detecting a current input to or output from the electrical storage device; and
a controller (26; 26A) ; wherein
the charger is suitable for receiving electric power supplied from the external power supply to charge the electrical storage device ;
the controller is configured so as to carry out offset correction of the current sensor while the external power supply is connected to the electrical storage device via the charger, provided that:
(i) electric devices, including the charger, that are electrically connected to the electrical storage device and that operate during charging of the electrical storage device using the external power are turned off; and
(ii) a determination condition for determining that the current is zero on the basis of a value detected by the current sensor is satisfied; and
the controller is also configured so as to execute a process for preventing overcharging of the electrical storage device during charging of the electrical storage device using the external power, when the offset correction cannot be carried out, wherein the process includes a process of reducing an allowable input electric power that indicates an allowable value of electric power input to the electrical storage device.

2. The charging device according to claim 1, wherein
the controller is configured so as to execute forced charging control by which a charging current is reduced to charge the electrical storage device to a full charge state, when a voltage of the electrical storage device reaches a predetermined value during charging of the electrical storage device, and
the process includes a process of prohibiting the forced charging control.

3. The charging device according to claim 1, wherein the process includes a process of carrying out at least one of interrupting a power feed path through which electric power is supplied to the charger and interrupting a power feed path connecting the charger to the external power supply.

4. The charging device according to any one of claims 1 to 3, wherein the controller is configured to determine that the electric devices are turned off, when a turn-off command is output to the electric devices.

5. The charging device according to claim 4, wherein the controller is configured to determine that the electric devices are turned off, when the turn-off command is output to the electric devices and a response to the turn-off command is received from the electric devices.

6. The charging device according to any one of claims 1 to 5, wherein the electric devices include an auxiliary load (20) configured to operate during charging of the electrical storage device.

7. The charging device according to any one of claims 1 to 6, wherein the determination condition is satisfied when the value detected by the current sensor is lower than a predetermined threshold.

8. The charging device according to any one of claims 1 to 6, wherein the determination condition is satisfied when no ripple fluctuations are detected in the value detected by the current sensor.

9. The charging device according to any one of claims 1 to 6, wherein the determination condition is satisfied when a variation in the value detected by the current sensor before and after a turn-off of the electric devices exceeds a predetermined threshold.

10. The charging device according to any one of claims 1 to 9, wherein the controller is configured to carry out the offset correction of the current sensor in response to a command for the offset correction of the current sensor while the external power supply is connected to the electrical storage device via the charger, provided that:
(i) the electric devices, including the charger, that are electrically connected to the electrical storage device and that operate during charging of the electrical storage device are turned off; and
(ii) the determination condition for determining that the current is zero on the basis of the value detected by the current sensor is satisfied.

11. The charging device according to claim 10, wherein the controller is configured to carry out the offset correction of the current sensor in response to the command for the offset correction of the current sensor during charging of the electrical storage device while the external power supply is connected to the electrical storage device via the charger, provided that:
(i) the electric devices, including the charger, that are electrically connected to the electrical storage device and that operate during charging of the electrical storage device are turned off; and
(ii) the determination condition for determining that the current is zero on the basis of the value detected by the current sensor is satisfied.

12. The charging device according to any one of claims 1 to 11, wherein the electric devices are all of electric devices, including the charger, that are electrically connected to the electrical storage device and that operate during charging of the electrical storage device.

13. A vehicle (10; 10A) **characterized by** comprising:
an electrical storage device (12); and
the charging device according to any one of claims 1 to 12.

14. An offset correction method for a current sensor (28) that is used in a vehicle (10; 10A) charging device that charges an electrical storage device (12) using an external power supply outside the vehicle, wherein the vehicle includes: the electrical storage device; a charger (24) that receives electric power supplied from the external power supply to charge the electrical storage device; and a current sensor that detects a current input to or output from the electrical storage device, the offset correction method comprising:
determining whether electric devices, including the charger, that are electrically connected to the electrical storage device and that operate during charging of the electrical storage device using the external power supply are turned off;
determining whether a determination condition for determining that the current is zero on the basis of a value detected by the current sensor is satisfied; and
carrying out offset correction of the current sensor while the external power supply is connected to the electrical storage device via the charger, provided that:
(i) it is determined that the electric devices are turned off; and
(ii) it is determined that the determination condition is satisfied ;
wherein, when it is determined that the offset correction cannot be carried out, a process for preventing overcharging of the electrical storage device during charging of the electrical storage device using the external power supply is executed, the process including process of reducing an allowable input electric power that indicates an allowable value of electric power input to the electrical storage device.

15. The offset correction method according to claim 14, wherein;
the offset correction of the current sensor is carried out in response to a command for the offset correction of the current sensor during charging of the electrical storage device while the external power supply is connected to the electrical storage device via the charger, provided that:
(i) it is determined that the electric devices are turned off; and
(ii) it is determined that the determination condition is satisfied.

16. The offset correction method according to claim 14 or 15, wherein the electric devices are all of electric devices, including the charger, that are electrically connected to the electrical storage device and that operate during charging of the electrical storage device.

## Patentansprüche

1. Ladevorrichtung für ein Fahrzeug (10; 10A), die eine elektrische Speichervorrichtung (12) mittels einer externen Energieversorgung außerhalb des Fahrzeugs auflädt, wobei die Ladevorrichtung umfasst:
ein Ladegerät (24),
einen Stromsensor (28) zum Detektieren eines Stroms, der in die elektrische Speichervorrichtung eingespeist oder davon abgegeben wird, und
eine Steuervorrichtung (26; 26A),
wobei das Ladegerät zum Empfangen von elektrischer Energie geeignet ist, die von der externen Energieversorgung zugeführt wird, um die elektrische Speichervorrichtung aufzuladen,
wobei die Steuervorrichtung dazu ausgebildet ist, eine Offsetkorrektur des Stromsensors durchzuführen, während die externe Energieversorgung über das Ladegerät mit der elektrischen Speichervorrichtung verbunden ist, vorausgesetzt, dass:
(i) elektrische Vorrichtungen, einschließlich des Ladegeräts, die an die elektrische Speichervorrichtung elektrisch angeschlossen sind und die während des Ladens der elektrischen Speichervorrichtung mittels der externen Energie betrieben werden, ausgeschaltet sind, und
(ii) eine Bestimmungsbedingung zum Bestimmen auf der Basis eines durch den Stromsensor detektierten Wertes, dass der Strom Null ist, erfüllt ist, und
wobei die Steuervorrichtung auch dazu ausgebildet ist, einen Prozess zum Verhindern des Überladens der elektrischen Speichervorrichtung während des Ladens der elektrischen Speichervorrichtung mittels der externen Energie durchzuführen, wenn die Offsetkorrektur nicht durchgeführt werden kann, wobei der Prozess einen Prozess zum Reduzieren einer zulässigen elektrischen Einspeiseenergie umfasst, der einen zulässigen Wert der zu der elektrischen Speichervorrichtung eingespeisten Energie angibt.

2. Ladevorrichtung nach Anspruch 1, wobei
die Steuervorrichtung dazu ausgebildet ist, Zwangsladeregelung durchzuführen, durch welche ein Ladestrom reduziert wird, um die elektrische Speichervorrichtung auf einen vollen Ladezustand aufzuladen, wenn eine Spannung der elektrischen Speichervorrichtung während des Ladens der elektrischen Speichervorrichtung einen vorgegebenen Wert erreicht, und
der Prozess einen Prozess des Sperrens der Zwangsladeregelung umfasst.

3. Ladevorrichtung nach Anspruch 1, wobei der Prozess einen Prozess des Durchführens von mindestens einem aus der Gruppe umfassend Unterbrechen eines Energiespeisewegs, durch den elektrische Energie dem Ladegerät zugeführt wird, und Unterbrechen eines Energiespeisewegs, der das Ladegerät mit der externen Energieversorgung verbindet, umfasst.

4. Ladevorrichtung nach einem beliebigen der Ansprüche 1 bis 3, wobei die Steuervorrichtung dazu ausgebildet ist, zu bestimmen, dass die elektrischen Vorrichtungen ausgeschaltet sind, wenn ein Ausschaltbefehl an die elektrischen Vorrichtungen ausgegeben wird.

5. Ladevorrichtung nach Anspruch 4, wobei die Steuervorrichtung dazu ausgebildet ist, zu bestimmen, dass die elektrischen Vorrichtungen ausgeschaltet sind, wenn der Ausschaltbefehl an die elektrischen Vorrichtungen ausgegeben wird und eine Antwort auf den Ausschaltbefehl von den elektrischen Vorrichtungen empfangen wird.

6. Ladevorrichtung nach einem beliebigen der Ansprüche 1 bis 5, wobei die elektrischen Vorrichtungen eine Hilfslast (20) umfassen, die dazu ausgebildet ist, während des Ladens der elektrischen Speichervorrichtung betrieben zu werden.

7. Ladevorrichtung nach einem beliebigen der Ansprüche 1 bis 6, wobei die Bestimmungsbedingung erfüllt ist, wenn der durch den Stromsensor detektierte Wert kleiner als eine vorgegebene Schwelle ist.

8. Ladevorrichtung nach einem beliebigen der Ansprüche 1 bis 6, wobei die Bestimmungsbedingung erfüllt ist, wenn keine Welligkeitsschwankungen in dem durch den Stromsensor detektierten Wert detektiert werden.

9. Ladevorrichtung nach einem beliebigen der Ansprüche 1 bis 6, wobei die Bestimmungsbedingung erfüllt ist, wenn eine Schwankung in dem durch den Stromsensor detektierten Wert vor und nach einem Abschalten der elektrischen Vorrichtungen eine vorgegebene Schwelle überschreitet.

10. Ladevorrichtung nach einem beliebigen der Ansprüche 1 bis 9, wobei die Steuervorrichtung dazu ausgebildet ist, die Offsetkorrektur des Stromsensors in Abhängigkeit von einem Befehl für die Offsetkorrektur des Stromsensors durchzuführen, während die externe Energieversorgung über das Ladegerät mit der elektrischen Speichervorrichtung verbunden ist, vorausgesetzt, dass:
(i) die elektrischen Vorrichtungen, einschließlich des Ladegeräts, die an die elektrische Speichervorrichtung elektrisch angeschlossen sind und die während des Ladens der elektrischen Speichervorrichtung betrieben werden, ausgeschaltet sind, und
(ii) eine Bestimmungsbedingung zum Bestimmen auf der Basis des durch den Stromsensor detektierten Wertes, dass der Strom Null ist, erfüllt ist.

11. Ladevorrichtung nach Anspruch 10, wobei die Steuervorrichtung dazu ausgebildet ist, die Offsetkorrektur des Stromsensors in Abhängigkeit von dem Befehl für die Offsetkorrektur des Stromsensors während des Ladens der elektrischen Speichervorrichtung durchzuführen, während die externe Energieversorgung über das Ladegerät mit der elektrischen Speichervorrichtung verbunden ist, vorausgesetzt, dass:
(i) die elektrischen Vorrichtungen, einschließlich des Ladegeräts, die an die elektrische Speichervorrichtung elektrisch angeschlossen sind und die während des Ladens der elektrischen Speichervorrichtung betrieben werden, ausgeschaltet sind, und
(ii) eine Bestimmungsbedingung zum Bestimmen auf der Basis des durch den Stromsensor detektierten Wertes, dass der Strom Null ist, erfüllt ist.

12. Ladevorrichtung nach einem beliebigen der Ansprüche 1 bis 11, wobei die elektrischen Vorrichtungen alle elektrischen Vorrichtungen, einschließlich des Ladegeräts, sind, die an die elektrische Speichervorrichtung elektrisch angeschlossen sind und die während des Ladens der elektrischen Speichervorrichtung betrieben werden.

13. Fahrzeug (10; 10A), **dadurch gekennzeichnet, dass** es umfasst:
eine elektrische Speichervorrichtung (12), und
die Ladevorrichtung nach einem beliebigen der Ansprüche 1 bis 12.

14. Offsetkorrekturverfahren für einen Stromsensor (28), der in einer Ladevorrichtung für ein Fahrzeug (10; 10A) verwendet wird, die eine elektrische Speichervorrichtung (12) mittels einer externen Energieversorgung außerhalb des Fahrzeugs auflädt, wobei das Fahrzeug umfasst: die elektrische Speichervorrichtung, ein Ladegerät (24), das elektrische Energie empfängt, die von der externen Energieversorgung zugeführt wird, um die elektrische Speichervorrichtung aufzuladen, und einen Stromsensor, der einen Strom detektiert, der in die elektrische Speichervorrichtung eingespeist oder davon abgegeben wird, wobei das Offsetkorrekturverfahren umfasst:
Bestimmen, ob elektrische Vorrichtungen, einschließlich des Ladegeräts, die an die elektrische Speichervorrichtung elektrisch angeschlossen sind und die während des Ladens der elektrischen Speichervorrichtung mittels der externen Energieversorgung betrieben werden, ausgeschaltet sind,
Bestimmen, ob eine Bestimmungsbedingung zum Bestimmen auf der Basis des durch den Stromsensor detektierten Wertes, dass der Strom Null ist, erfüllt ist, und
Durchführen der Offsetkorrektur des Stromsensors, während die externe Energieversorgung über das Ladegerät mit der elektrischen Speichervorrichtung verbunden ist, vorausgesetzt, dass:
(i) bestimmt wird, dass die elektrischen Vorrichtungen ausgeschaltet sind, und
(ii) bestimmt wird, dass die Bestimmungsbedingung erfüllt ist,
wobei, wenn bestimmt wird, dass die Offsetkorrektur nicht durchgeführt werden kann, ein Prozess zum Verhindern des Überladens der elektrischen Speichervorrichtung während des Ladens der elektrischen Speichervorrichtung mittels der externen Energieversorgung durchgeführt wird, wobei der Prozess einen Prozess zum Reduzieren einer zulässigen elektrischen Einspeiseenergie umfasst, der einen zulässigen Wert der zu der elektrischen Speichervorrichtung eingespeisten Energie angibt.

15. Offsetkorrekturverfahren nach Anspruch 14, wobei
die Offsetkorrektur des Stromsensors in Abhängigkeit von einem Befehl für die Offsetkorrektur des Stromsensors während des Ladens der elektrischen Speichervorrichtung durchgeführt wird, während die externe Stromversorgung über das Ladegerät mit der elektrischen Speichervorrichtung verbunden ist, vorausgesetzt, dass:
(i) bestimmt wird, dass die elektrischen Vorrichtungen ausgeschaltet sind, und
(ii) bestimmt wird, dass die Bestimmungsbedingung erfüllt ist.

16. Offsetkorrekturverfahren nach Anspruch 14 oder 15, wobei die elektrischen Vorrichtungen alle elektrischen Vorrichtungen, einschließlich des Ladegeräts, sind, die an die elektrische Speichervorrichtung elektrisch angeschlossen sind und die während des Ladens der elektrischen Speichervorrichtung betrieben werden.

## Revendications

1. Dispositif de charge pour un véhicule (10 ; 10A), qui charge un dispositif de stockage électrique (12) en utilisant une alimentation externe à l'extérieur du véhicule, le dispositif de charge comportant :
un chargeur (24) ;
un capteur de courant (28) destiné à détecter une entrée ou une sortie de courant du dispositif de stockage électrique ; et
un dispositif de commande (26 ; 26A) ;
dans lequel
le chargeur est approprié pour recevoir de l'énergie électrique délivrée par l'alimentation externe pour charger le dispositif de stockage électrique ;
le dispositif de commande est configuré de façon à réaliser une correction de compensation du capteur de courant alors que l'alimentation externe est reliée au dispositif de stockage électrique par l'intermédiaire du chargeur, à condition que :
(i) des dispositifs électriques, y compris le chargeur, qui sont électriquement reliés au dispositif de stockage électrique et qui fonctionnent pendant la charge du dispositif de stockage électrique en utilisant l'alimentation externe soient arrêtés ; et
(ii) une condition de détermination pour déterminer que le courant est zéro sur la base d'une valeur détectée par le capteur de courant soit satisfaite ; et
le dispositif de commande est également configuré de façon à exécuter un processus pour empêcher une surcharge du dispositif de stockage électrique pendant la charge du dispositif de stockage électrique en utilisant l'alimentation externe, quand la correction de compensation ne peut pas être réalisée, le processus incluant un processus de réduction d'une énergie électrique d'entrée admissible qui indique une valeur admissible d'énergie électrique entrée dans le dispositif de stockage électrique.

2. Dispositif de charge selon la revendication 1, dans lequel
le dispositif de commande est configuré de façon à exécuter une commande de charge forcée grâce à laquelle un courant de charge est réduit pour charger le dispositif de stockage électrique à un état de charge complète, quand une tension du dispositif de stockage électrique atteint une valeur prédéterminée pendant la charge du dispositif de stockage électrique, et
le processus comprend un processus d'interdiction de la commande de charge forcée.

3. Dispositif de charge selon la revendication 1, dans lequel le processus comprend un processus de réalisation d'au moins une d'une interruption d'un passage d'alimentation en énergie par l'intermédiaire duquel de l'énergie électrique est délivrée au chargeur et d'interruption d'un passage d'alimentation en énergie reliant le chargeur à l'alimentation externe.

4. Dispositif de charge selon l'une quelconque des revendications 1 à 3, dans lequel le dispositif de commande est configuré pour déterminer que les dispositifs électriques sont arrêtés, quand une commande d'arrêt est délivrée aux dispositifs électriques.

5. Dispositif de charge selon la revendication 4, dans lequel le dispositif de commande est configuré pour déterminer que les dispositifs électriques sont arrêtés, quand la commande d'arrêt est délivrée aux dispositifs électriques et une réponse à la commande d'arrêt est reçue des dispositifs électriques.

6. Dispositif de charge selon l'une quelconque des revendications 1 à 5, dans lequel les dispositifs électriques comprennent une charge auxiliaire (20) configurée pour fonctionner pendant la charge du dispositif de stockage électrique.

7. Dispositif de charge selon l'une quelconque des revendications 1 à 6, dans lequel la condition de détermination est satisfaite quand la valeur détectée par le capteur de courant est inférieure à un seuil prédéterminé.

8. Dispositif de charge selon l'une quelconque des revendications 1 à 6, dans lequel la condition de détermination est satisfaite quand aucune fluctuation d'ondulation n'est détectée dans la valeur détectée par le capteur de courant.

9. Dispositif de charge selon l'une quelconque des revendications 1 à 6, dans lequel la condition de détermination est satisfaite quand une variation de la valeur détectée par le capteur de courant avant et après un arrêt des dispositifs électriques dépasse un seuil prédéterminé.

10. Dispositif de charge selon l'une quelconque des revendications 1 à 9, dans lequel le dispositif de commande est configuré pour réaliser la correction de compensation du capteur de courant en réponse à une commande pour la correction de compensation du capteur de courant alors que l'alimentation externe est reliée au dispositif de stockage électrique par l'intermédiaire du chargeur, à condition que :
(i) les dispositifs électriques, y compris le chargeur, qui sont électriquement reliés au dispositif de stockage électrique et qui fonctionnent pendant la charge du dispositif de stockage électrique soient arrêtés ; et
(ii) la condition de détermination pour déterminer que le courant est zéro sur la base de la valeur détectée par le capteur de courant soit satisfaite.

11. Dispositif de charge selon la revendication 10, dans lequel le dispositif de commande est configuré pour réaliser la correction de compensation du capteur de courant en réponse à la commande pour la correction de compensation du capteur de courant pendant la charge du dispositif de stockage électrique alors que l'alimentation externe est reliée au dispositif de stockage électrique par l'intermédiaire du chargeur, à condition que :
(i) les dispositifs électriques, y compris le chargeur, qui sont électriquement reliés au dispositif de stockage électrique et qui fonctionnent pendant la charge du dispositif de stockage électrique soient arrêtés ; et
(ii) la condition de détermination pour déterminer que le courant est zéro sur la base de la valeur détectée par le capteur de courant soit satisfaite.

12. Dispositif de charge selon l'une quelconque des revendications 1 à 11, dans lequel les dispositifs électriques sont tous des dispositifs électriques, y compris le chargeur, qui sont électriquement reliés au dispositif de stockage électrique et qui fonctionnent pendant la charge du dispositif de stockage électrique.

13. Véhicule (10 ; 10A) **caractérisé en ce qu'**il comporte :
un dispositif de stockage électrique (12) ; et
le dispositif de charge selon l'une quelconque des revendications 1 à 12.

14. Procédé de correction de compensation pour un capteur de courant (28) qui est utilisé dans un dispositif de charge de véhicule (10 ; 10A) qui charge un dispositif de stockage électrique (12) en utilisant une alimentation externe à l'extérieur du véhicule, dans lequel le véhicule comprend : le dispositif de stockage électrique ; un chargeur (24) qui reçoit de l'énergie électrique délivrée par l'alimentation externe pour charger le dispositif de stockage électrique ; et un capteur de courant qui détecte une entrée ou une sortie de courant du dispositif de stockage électrique, le procédé de correction de compensation comportant le fait de :
déterminer si des dispositifs électriques, y compris le chargeur, qui sont électriquement reliés au dispositif de stockage électrique et qui fonctionnent pendant la charge du dispositif de stockage électrique en utilisant l'alimentation externe sont arrêtés ;
déterminer si une condition de détermination pour déterminer que le courant est zéro sur la base d'une valeur détectée par le capteur de courant est satisfaite ; et
réaliser une correction de compensation du capteur de courant alors que l'alimentation externe est reliée au dispositif de stockage électrique par l'intermédiaire du chargeur, à condition que :
(i) on détermine que les dispositifs électriques sont arrêtés ; et
(ii) on détermine que la condition de détermination est satisfaite ;
selon lequel, lorsque l'on détermine que la correction de compensation ne peut pas être réalisée, un processus destiné à empêcher une surcharge du dispositif de stockage électrique pendant la charge du dispositif de stockage électrique en utilisant l'alimentation externe est exécuté, le processus comprenant un processus de réduction d'une énergie électrique d'entrée admissible qui indique une valeur admissible d'énergie électrique introduite dans le dispositif de stockage électrique.

15. Procédé de correction de compensation selon la revendication 14, selon lequel ;
la correction de compensation du capteur de courant est réalisée en réponse à une commande pour la correction de compensation du capteur de courant pendant la charge du dispositif de stockage électrique alors que l'alimentation externe est reliée au dispositif de stockage électrique par l'intermédiaire du chargeur, à condition que :
(i) on détermine que les dispositifs électriques sont arrêtés ; et
(ii) on détermine que la condition de détermination est satisfaite.

16. Procédé de correction de compensation selon la revendication 14 ou 15, selon lequel les dispositifs électriques sont tous des dispositifs électriques, y compris le chargeur, qui sont électriquement reliés au dispositif de stockage électrique et qui fonctionnent pendant la charge du dispositif de stockage électrique.
